# EUROPEAN PATENT APPLICATION

(11) **EP 4 841 890 A1**
(43) Date of publication of application: **18.11.2026**
(21) Application number: 24923596.1
(22) Date of filing: 31.12.2024
(51) Int. Cl.: H03F 1/56

(54) **POWER AMPLIFIER, RADIO FREQUENCY FRONT-END MODULE AND ELECTRONIC DEVICE**

(30) Priority: 06.02.2024 CN 202410168826
(71) Applicant: Huawei Technologies Co., Ltd., Shenzhen, Guangdong 518129 (CN)
(72) Inventor: CHEN, Yi, Shenzhen, Guangdong 518129 (CN)
(74) Representative: Thun, Clemens
(86) International application number: PCT/CN2024/144350
(87) International publication number: WO 2025/167394

(57) **Abstract**

This application discloses a power amplifier, a radio frequency front-end module, and an electronic device. The power amplifier includes a first amplifier, a second amplifier, a first transformer, a second transformer, and a first capacitor. A first end of a secondary coil of the second transformer, a second end of a secondary coil of the first transformer, and a first end of the first capacitor are coupled to a point, and a second end of the first capacitor is grounded. In this case, the first capacitor, a parasitic inductance of the secondary coil of the first transformer, and a parasitic inductance of the secondary coil of the second transformer form a T-shaped network. The T-shaped network is configured to convert a load impedance into a load impedance required by the first amplifier, thereby achieving an equivalent effect of a λ/4 transmission line and replacing the λ/4 transmission line with the T-shaped network. Because the inductors in the T-shaped network are the parasitic inductances of the secondary coils, additional inductor area can be saved, thereby reducing costs and area.

## Description

### CROSS-REFERENCE TO RELATED APPLICATIONS

This application claims priority to Chinese Patent Application No. 202410168826.2, filed with the China National Intellectual Property Administration on February 6, 2024 and entitled "POWER AMPLIFIER, RADIO FREQUENCY FRONT-END MODULE, AND ELECTRONIC DEVICE", which is incorporated herein by reference in its entirety.

### TECHNICAL FIELD

This application relates to the field of power amplification technologies, and in particular, to a power amplifier, a radio frequency front-end module, and an electronic device.

### BACKGROUND

In a radio frequency front-end module, a power amplifier is a key component that determines energy efficiency of the module. Generally, efficiency of a conventional power amplifier decreases during power back-off, but when load modulation is implemented via a Doherty power amplifier, the efficiency of the power amplifier during back-off can be effectively improved. However, to implement load modulation, a quarter-wavelength (λ/4) transmission line or an equivalent impedance transformation network usually needs to be disposed at an output end of the Doherty power amplifier to perform load impedance modulation, so as to implement impedance matching. Consequently, more matching devices are required in the Doherty power amplifier to meet impedance matching requirements, resulting in increased costs and an increased area of the Doherty power amplifier.

### SUMMARY

This application provides a power amplifier, a radio frequency front-end module, and an electronic device, to reduce costs and area.

According to a first aspect, an embodiment of this application provides a power amplifier. The power amplifier includes a first amplifier, a second amplifier, a first transformer, a second transformer, and a first capacitor, where an output end of the first amplifier is coupled to at least one end of a primary coil of the first transformer, an output end of the second amplifier is coupled to at least one end of a primary coil of the second transformer, a first end of a secondary coil of the first transformer is a first output end, a second end of the secondary coil of the first transformer, a first end of a secondary coil of the second transformer, and a first end of the first capacitor are coupled to a point, a second end of the secondary coil of the second transformer is grounded, and a second end of the first capacitor is grounded. In this way, the first amplifier amplifies a radio frequency signal, and couples an amplified radio frequency signal to the secondary coil of the first transformer through the primary coil of the first transformer. The second amplifier amplifies a radio frequency signal, and couples an amplified radio frequency signal to the secondary coil of the second transformer through the primary coil of the second transformer. Then, the amplified radio frequency signals are coupled in series through the secondary coils of the first transformer and the second transformer, so that power combination of the first amplifier and the second amplifier is implemented. A radio frequency signal obtained through power combination is output to a power output end through the first end of the secondary coil of the first transformer. In addition, the first capacitor, a parasitic inductance of the secondary coil of the first transformer, and a parasitic inductance of the secondary coil of the second transformer form a T-shaped network, and the T-shaped network is used to convert a load impedance into a load impedance required by the first amplifier. In this way, the parasitic inductance of the secondary coil of the first transformer and the parasitic inductance of the secondary coil of the secondary transformer are reused, so that the first capacitor, the parasitic inductance of the secondary coil of the first transformer, and the parasitic inductance of the secondary coil of the second transformer form the T-shaped network, and the T-shaped network is used to convert the load impedance into the load impedance required by the first amplifier, thereby achieving an equivalent effect of a λ/4 transmission line and replacing the λ/4 transmission line with the T-shaped network. In addition, the inductors in the T-shaped network are the parasitic inductances of the secondary coils, and are not impedance matching elements additionally disposed in the T-shaped network. Therefore, additional inductor area is saved in a chip integration design. If discrete devices are integrated, additional inductor BOM costs are saved. In addition, only the first capacitor is an impedance matching element additionally disposed in the T-shaped network. Therefore, the T-shaped network does not need to be provided with a large quantity of impedance matching elements, and can achieve an equivalent effect of a λ/4 transmission line to replace the λ/4 transmission line, thereby reducing costs and area.

In some embodiments, the first amplifier and the second amplifier are completely symmetrically designed, and the first transformer and the second transformer are also completely symmetrically designed, so that a compact matching network design can be implemented, and devices can be completely symmetrically designed for main and auxiliary power amplifiers.

The power amplifier in this embodiment of this application may be a Doherty (Doherty) power amplifier, and can improve efficiency during power back-off.

In some embodiments, the first amplifier, the second amplifier, the first transformer, the second transformer, and the first capacitor are packaged together. In this way, integration can be improved, and a chip can be formed.

In some embodiments, the power amplifier further includes a circuit board, where the first capacitor, a ground end, and the first output end are disposed on the circuit board, the first amplifier, the second amplifier, the first transformer, and the second transformer are packaged together and then coupled to the first capacitor, the first end of the secondary coil of the first transformer is coupled to the first output end on the circuit board, and the second end of the secondary coil of the second transformer is coupled to the ground end on the circuit board. In this way, the first amplifier, the second amplifier, the first transformer, and the second transformer may be packaged together to form a chip, and some components are disposed on the circuit board, so that a size of the chip can be reduced.

In some embodiments, the power amplifier further includes a first switch and a second switch, where a first end of the first switch is coupled to the first end of the first capacitor, and a second end of the first switch is grounded; and the second end of the secondary coil of the second transformer is grounded through the second switch, and the second end of the secondary coil of the second transformer is a second output end. In this way, the power amplifier in this embodiment of this application may be switched between a Doherty power amplifier and a multi-channel multiple-input multiple-output (Multiple-input multiple-output, MIMO) power amplifier by turning on and off the first switch and the second switch, so that the same power amplifier in this embodiment of this application can be applied to different application scenarios.

To set the power amplifier in this embodiment of this application as a Doherty power amplifier, in some embodiments, in response to a case in which the first switch is turned off and the second switch is turned on, the second end of the secondary coil of the first transformer and the first end of the secondary coil of the second transformer are coupled to the first capacitor, and the second end of the secondary coil of the second transformer is grounded. In this way, the power amplifier in this embodiment of this application is set as a Doherty power amplifier.

To set the power amplifier in this embodiment of this application as a MIMO power amplifier, in some embodiments, in response to a case in which the first switch is turned on and the second switch is turned off, the second end of the secondary coil of the first transformer and the first end of the secondary coil of the second transformer are coupled to the ground end, and the second end of the secondary coil of the second transformer is coupled to the second output end. In this way, the power amplifier in this embodiment of this application is set as a MIMO power amplifier.

In some embodiments, the first amplifier, the second amplifier, the first transformer, the second transformer, the first capacitor, the first switch, and the second switch are packaged together. In this way, integration can be improved, and a chip can be formed.

In some embodiments, the power amplifier further includes a second capacitor and a third capacitor, where a first end of the second capacitor is coupled to a first end of the primary coil of the first transformer or grounded, and a second end of the second capacitor is coupled to a second end of the primary coil of the first transformer; and a first end of the third capacitor is coupled to a first end of the primary coil of the second transformer or grounded, and a second end of the third capacitor is coupled to a second end of the primary coil of the second transformer. In this way, the parasitic inductance of the secondary coil of the first transformer is adjusted via the second capacitor, and the parasitic inductance of the secondary coil of the second transformer is adjusted via the third capacitor.

In some embodiments, a capacitance value of the first capacitor, a capacitance value of the second capacitor, and a capacitance value of the third capacitor are separately adjustable. The parasitic inductance of the secondary coil of the first transformer is tuned by adjusting the capacitance value of the second capacitor, the parasitic inductance of the secondary coil of the second transformer is tuned by adjusting the capacitance value of the third capacitor, and a frequency selection characteristic of the T-shaped network is implemented in combination with tuning of the first capacitor. In other words, a multi-band adjustable T-shaped network is implemented, so that the power amplifier in this embodiment of this application implements an effect of a broadband power amplifier.

In some embodiments, Ropt (namely, an optimal load impedance of a transistor) of an output impedance of the power amplifier may be adjusted by adjusting the capacitance value of the first capacitor CZ, the capacitance value of the second capacitor CM, and the capacitance value of the third capacitor CA.

In some embodiments, at least one of the first capacitor, the second capacitor, and the third capacitor is set as a switched capacitor array, so that the switched capacitor array can be switched based on an operating frequency of the power amplifier.

In some embodiments, at least one of the first capacitor, the second capacitor, and the third capacitor may alternatively be separately set as a variable capacitor, and can also be switched based on an operating frequency of the power amplifier.

In some embodiments, an input end of the first amplifier is a differential input end, the output end of the first amplifier is a differential output end, the differential output end of the first amplifier is separately coupled to the first end and the second end of the primary coil of the first transformer, and a center tap of the primary coil of the first transformer is configured to be coupled to a first power supply. In this way, the first amplifier can implement differential input and output.

In some embodiments, an input end of the second amplifier is a differential input end, the output end of the second amplifier is a differential output end, the differential output end of the second amplifier is coupled to the first end and the second end of the primary coil of the second transformer, and a center tap of the primary coil of the second transformer is configured to be coupled to a second power supply. In this way, the second amplifier can implement differential input and output.

In some embodiments, the output end of the first amplifier is coupled to the second end of the primary coil of the first transformer, and the first end of the primary coil of the first transformer is configured to be coupled to a first power supply. In this way, the first amplifier can implement single-ended input and single-ended output.

In some embodiments, the output end of the second amplifier is coupled to the second end of the primary coil of the second transformer, and the first end of the primary coil of the second transformer is configured to be coupled to a second power supply. In this way, the second amplifier can implement single-ended input and single-ended output.

In some embodiments, the first end of the primary coil of the first transformer may be a positive end of the first transformer, and the second end of the primary coil of the first transformer may be a negative end of the first transformer. Alternatively, the first end of the primary coil of the first transformer may be a negative end of the first transformer, and the second end of the primary coil of the first transformer may be a positive end of the first transformer.

In some embodiments, the first end of the primary coil of the second transformer may be a positive end of the second transformer, and the second end of the primary coil of the second transformer may be a negative end of the second transformer. Alternatively, the first end of the primary coil of the second transformer may be a negative end of the second transformer, and the second end of the primary coil of the second transformer may be a positive end of the second transformer.

In some embodiments, the first transformer is set as a balun coil, and the balun coil is used as an output matching transformer of the first amplifier.

In some embodiments, the second transformer is set as a balun coil, and the balun coil is used as an output matching transformer of the second amplifier.

According to a second aspect, an embodiment of this application further provides a power amplifier. The power amplifier includes a first amplifier, a second amplifier, a first transformer, a second transformer, and a circuit board, where an output end of the first amplifier is coupled to at least one end of a primary coil of the first transformer, an output end of the second amplifier is coupled to at least one end of a primary coil of the second transformer, a first end of a secondary coil of the first transformer is a first output end, and a second end of the secondary coil of the first transformer and a first end of a secondary coil of the second transformer are coupled to a point; and the first output end, a second output end, and a ground end are disposed on the circuit board, the first amplifier, the second amplifier, the first transformer, and the second transformer are packaged together, the second end of the secondary coil of the first transformer and the first end of the secondary coil of the second transformer are coupled to the ground end on the circuit board, the first end of the secondary coil of the first transformer is coupled to the first output end, and a second end of the secondary coil of the second transformer is coupled to the second output end. In this way, the power amplifier in this embodiment of this application may be set as a MIMO power amplifier.

In addition, for implementations of other structures in the embodiments of the second aspect, refer to implementations of corresponding structures in any embodiment of the first aspect. Details are not described herein again.

According to a third aspect, an embodiment of this application further provides a radio frequency front-end module, where the radio frequency front-end module includes a power amplifier. The power amplifier is the power amplifier according to the first aspect or any one of the embodiments of the first aspect. Alternatively, the power amplifier is the power amplifier according to the second aspect or any one of the embodiments of the second aspect.

According to a fourth aspect, an embodiment of this application further provides an electronic device, where the electronic device includes a radio frequency front-end module. The radio frequency front-end module is the radio frequency front-end module according to any one of the embodiments of the third aspect.

In addition, for technical effect of the corresponding solutions in the third aspect and the fourth aspect, refer to technical effect that can be obtained by using the corresponding solutions in the first aspect and the second aspect. Repeated content is not described in detail.

### BRIEF DESCRIPTION OF DRAWINGS

FIG. 1 is a diagram of a structure of an electronic device according to an embodiment of this application;
FIG. 2 is a diagram of a structure of a power amplifier according to an embodiment of this application;
FIG. 3 is a diagram of a structure of a T-shaped network according to an embodiment of this application;
FIG. 4 is a diagram of a cascode + stack structure;
FIG. 5 is a diagram of another structure of a power amplifier according to an embodiment of this application;
FIG. 6 is a diagram of another structure of a power amplifier according to an embodiment of this application;
FIG. 7 is a diagram of another cascode + stack structure;
FIG. 8 is a diagram of another structure of a power amplifier according to an embodiment of this application;
FIG. 9a is a diagram of a structure of the power amplifier shown in FIG. 8 when the power amplifier is set as a Doherty power amplifier;
FIG. 9b is a diagram of a structure of the power amplifier shown in FIG. 8 when the power amplifier is set as a MIMO power amplifier;
FIG. 10 is a diagram of another structure of a power amplifier according to an embodiment of this application;
FIG. 11 is a diagram of another structure of a power amplifier according to an embodiment of this application; and
FIG. 12 is a diagram of another structure of a power amplifier according to an embodiment of this application.

Reference numerals:
100: baseband chip; 200: radio frequency system; 210: radio frequency transceiver unit; 220: radio frequency front-end module; 221: transmit link; 222: receive link; 230: antenna system; 231: main antenna; 232: diversity antenna; 10: power amplifier; 11M: first amplifier; 11A: second amplifier; 12M: first transformer; 12A: second transformer; 20: packaged device; 30: circuit board; CZ: first capacitor; PZ: amplification unit; O1/O2/O3/O4: differential output end; VDDM: first power supply; VDDA: second power supply; CM: second capacitor; CA: third capacitor; M0: node; RFZ1: first power transfer end; RFZ2: second power transfer end; INM/INM1/INM2: first power input end; INA/INA1/INA2: second power input end; RFO1: first output end; and RFO2: second output end.

### DESCRIPTION OF EMBODIMENTS

To make the objectives, technical solutions, and advantages of this application clearer, the following further describes this application in detail with reference to the accompanying drawings. A specific operation method in a method embodiment may also be applied to an apparatus embodiment or a system embodiment. It should be noted that in descriptions of this application, "at least one" means one or more, and "a plurality of" means two or more. In view of this, in embodiments of this application, "a plurality of" may also be understood as "at least two". The term "and/or" describes an association relationship for describing associated objects and represents that three relationships may exist. For example, A and/or B may represent the following three cases: Only A exists, both A and B exist, and only B exists. In addition, the character "/" generally indicates an "or" relationship between the associated objects. In addition, terms such as "first" and "second" are merely intended for a purpose of differentiated description, and should not be construed as an indication or an implication of relative importance, or an indication or an implication of a sequence. In addition, in embodiments of this application, "coupling" refers to an electrical connection, and that two electrical elements are coupled may be a direct or indirect connection between the two electrical elements. For example, that A is coupled to B may be that A is directly connected to B, or may be that A is indirectly connected to B through one or more other electrical elements. For example, that A is coupled to B may alternatively be that A is directly connected to C, C is directly connected to B, A and B are connected through C.

It should be noted that same reference numerals in the accompanying drawings of this application indicate same or similar structures. Therefore, repeated descriptions thereof are omitted. Expressions of positions and directions in this application are described by using the accompanying drawings as an example. However, changes may also be made as required, and all the changes fall within the protection scope of this application. The accompanying drawings in this application are merely used to illustrate relative positional relationships and do not represent an actual scale.

A power amplifier provided in embodiments of this application may be used in an electronic device having a radio frequency function. For example, the electronic device may be a cellular phone, a smartphone, a handheld wireless device with or without a phone function, or a wireless tablet computer. It should be noted that the power amplifier provided in embodiments of this application is intended to include but is not limited to being used in these and any other suitable types of electronic devices having a radio frequency function.

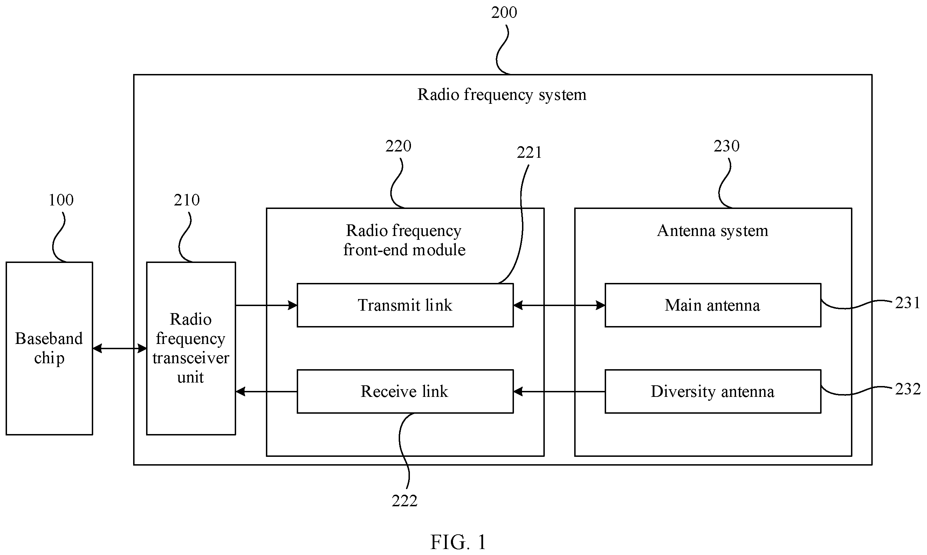

FIG. 1 is a diagram of a structure of an electronic device according to an embodiment of this application. Refer to FIG. 1. The electronic device may include a baseband chip 100 and a radio frequency system 200, and the radio frequency system 200 is coupled to the baseband chip 100. For example, the radio frequency system 200 includes a radio frequency transceiver unit 210, a radio frequency front-end module 220, and an antenna system 230. The baseband chip 100 is coupled to the radio frequency transceiver unit 210, the radio frequency transceiver unit 210 is coupled to the radio frequency front-end module 220, and the radio frequency front-end module 220 is further coupled to the antenna system 230. The antenna system 230 is configured to transmit and receive radio frequency signals. For example, the antenna system 230 includes a plurality of (for example, four) antennas, and the antennas are configured to transmit radio frequency signals of different frequency bands. The radio frequency transceiver unit 210 is coupled to a side that is of the radio frequency front-end module 220 and that is away from the antenna, and the radio frequency front-end module 220 is coupled to the antenna through an external interface. The radio frequency front-end module 220 includes a transmit link 221 and a receive link 222. There may be one or more transmit links 221 and one or more receive links 222. The transmit link 221 may be configured to transmit radio frequency signals of a plurality of different frequency bands, to transmit the radio frequency signals to the antenna system 230. The receive link 222 may receive radio frequency signals of a plurality of different frequency bands, to receive the radio frequency signals transmitted by the antenna system 230.

The baseband chip 100 may be disposed on a main circuit board of the electronic device, and is configured to: perform digital fundamental frequency signal processing, and encode and decode a digital fundamental frequency signal. The radio frequency transceiver unit 210 and the radio frequency front-end module 220 are also disposed on the main circuit board. The radio frequency transceiver unit 210 is configured to: perform conversion between a digital fundamental frequency signal and an analog radio frequency signal, process a digital fundamental frequency signal sent by the baseband chip 100 into an analog radio frequency signal, and then transmit the analog radio frequency signal to the transmit link 221 of the radio frequency front-end module 220. Alternatively, the radio frequency transceiver unit 210 is further configured to: receive an analog radio frequency signal transmitted by the receive link 222, convert the analog radio frequency signal into a digital fundamental frequency signal, and then send the digital fundamental frequency signal to the baseband chip 100. For example, the plurality of antennas in the antenna system 230 may be classified into a main antenna 231 and a diversity antenna 232. The radio frequency front-end module 220 is configured to: after performing processing such as amplification and filtering on an analog radio frequency signal, send the analog radio frequency signal to the main antenna 231, or receive an analog radio frequency signal from the main antenna 231 and the diversity antenna 232, to implement processing such as amplification and filtering on the analog radio frequency signal.

The baseband chip 100 and the radio frequency system 200 may form a wireless communication system conduction end of the electronic device. After the antenna system 230 receives a radio frequency signal (that is, a received signal) and sends the received signal to the radio frequency front-end module 220, the radio frequency front-end module 220 may perform processing such as amplification, filtering, and frequency mixing on the received signal via a radio frequency device in the receive link 222, and then input the received signal to the baseband chip 100 for demodulation. Correspondingly, when receiving a radio frequency signal (that is, a transmit signal) output by the baseband chip 100, the radio frequency transceiver unit 210 performs processing such as frequency mixing, amplification, and filtering on the transmit signal, outputs the transmit signal to the corresponding transmit link 221 in the radio frequency front-end module 220 through a frequency band in which the transmit signal is located, and sends the transmit signal to the corresponding main antenna 231 through the transmit link 221 for transmission. The radio frequency transceiver unit 210 is further configured to control switching between the transmit link 221 and the receive link 222 in the radio frequency front-end module 220. For example, the radio frequency transceiver unit 210 may include but is not limited to a radio frequency transceiver. In this way, the electronic device may perform wireless communication with a network device or another electronic device through the wireless communication system conduction end and a wireless network, to complete information receiving and sending between the electronic device and the network device or the another electronic device. The network device may include a server, a base station, or the like.

For example, the transmit link 221 may include but is not limited to a power amplifier 10, a filter, a radio frequency switch, and the like that are sequentially coupled, and the receive link 222 may include but is not limited to a low noise amplifier, a filter, a radio frequency switch, and the like that are sequentially coupled. Alternatively, in some embodiments, the transmit link 221 and the receive link 222 may be in other different forms. In this embodiment, composition of the transmit link 221 and the receive link 222 is not further limited. For details, refer to descriptions in a conventional related technology.

It should be noted that FIG. 1 merely shows an example of a structure form of the electronic device. During specific implementation, the receive link 222 may not be disposed in the radio frequency front-end module 220. In this case, the diversity antenna may not be disposed in the antenna system 230. In addition, in actual application, the baseband chip 100, the radio frequency transceiver unit 210, and the radio frequency front-end module 220 may be separately disposed in different chips, or any two of the baseband chip 100, the radio frequency transceiver unit 210, and the radio frequency front-end module 220 may be integrated into a same chip, or the baseband chip 100, the radio frequency transceiver unit 210, and the radio frequency front-end module 220 may be integrated into a same chip, to improve integration.

However, in a current power amplifier of a radio frequency front-end module, to reduce power consumption during power back-off, a λ/4 transmission line or an equivalent impedance transformation network is usually connected in series at an output end of the amplifier to perform load impedance modulation, and after combination, an impedance matching circuit is used to match the transmission impedance again for transmission. In this way, more impedance matching elements are usually required to meet requirements of impedance matching, resulting in increased costs and an increased area of the power amplifier 10. Therefore, an embodiment of this application provides a power amplifier 10 that can be used in a transmit link. In the power amplifier 10, a T-shaped network is formed, and λ/4 impedance matching is implemented through the T-shaped network, thereby reducing costs and area.

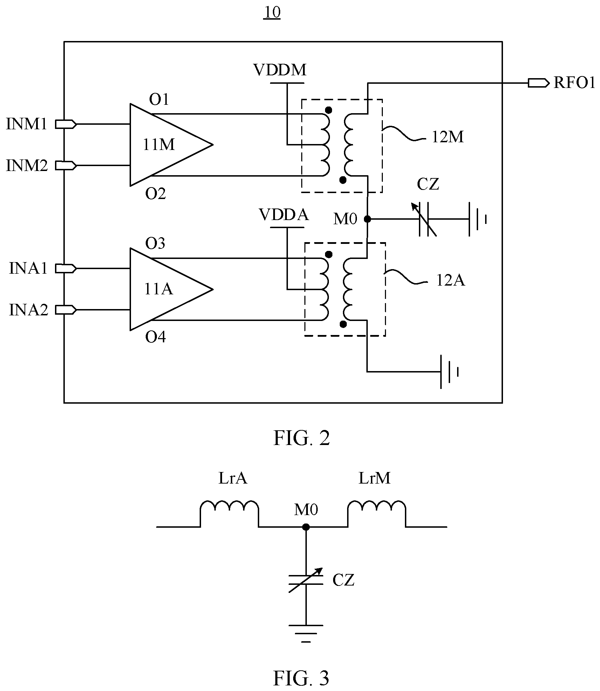

FIG. 2 is a diagram of a structure of a power amplifier according to an embodiment of this application. Refer to FIG. 2. The power amplifier 10 may include a first amplifier 11M, a second amplifier 11A, a first transformer 12M, a second transformer 12A, and a first capacitor CZ. An input end of the first amplifier 11M is coupled to a first power input end (for example, INM1 or INM2), and an output end of the first amplifier 11M is coupled to a primary coil of the first transformer 12M. In addition, an input end of the second amplifier 11A is coupled to a second power input end (for example, INA1 or INA2), an output end of the second amplifier 11A is coupled to a primary coil of the second transformer 12A, a first end of a secondary coil of the second transformer 12A and a second end of a secondary coil of the first transformer 12M are coupled to a node M0, a second end of the secondary coil of the second transformer 12A is grounded, and a first end of the secondary coil of the first transformer 12M is a first output end RFO1. In this way, a radio frequency signal is input to the first amplifier 11M through the first power input end (for example, INM1 or INM2), and the first amplifier 11M amplifies the radio frequency signal, and couples an amplified radio frequency signal to the secondary coil of the first transformer 12M through the primary coil of the first transformer 12M. In addition, a radio frequency signal is input to the second amplifier 11A through the second power input end (for example, INA1 or INA2), and the second amplifier 11A amplifies the radio frequency signal, and couples an amplified radio frequency signal to the secondary coil of the second transformer 12A through the primary coil of the second transformer 12A. Then, the amplified radio frequency signals are coupled in series through the secondary coils of the first transformer 12M and the second transformer 12A, so that power combination of the first amplifier 11M and the second amplifier 11A is implemented. A radio frequency signal obtained through power combination is output through the first end of the secondary coil of the first transformer 12M.

In addition, a first end of the first capacitor CZ is coupled to the node M0, and a second end of the first capacitor CZ is grounded. In this way, a parasitic inductance of the secondary coil of the first transformer 12M and a parasitic inductance of the secondary coil of the secondary transformer are reused, so that the first capacitor CZ, the parasitic inductance of the secondary coil of the first transformer 12M, and the parasitic inductance of the secondary coil of the second transformer 12A form a T-shaped network, and the T-shaped network is used to convert a load impedance into a load impedance required by the first amplifier 11M, thereby achieving an equivalent effect of a λ/4 transmission line and replacing the λ/4 transmission line with the T-shaped network, and reducing costs and area.

FIG. 3 is a diagram of a structure of a T-shaped network according to an embodiment of this application. Refer to FIG. 3. The T-shaped network includes a parasitic inductance LrM of a secondary coil of a first transformer 12M, a parasitic inductance LrA of a secondary coil of a second transformer 12A, and a first capacitor CZ coupled to a node M0. LrM is the parasitic inductance of the secondary coil of the first transformer 12M, and is not an impedance matching element additionally disposed in the T-shaped network. LrA is the parasitic inductance of the secondary coil of the second transformer 12A, and is not an impedance matching element additionally disposed in the T-shaped network. Therefore, additional inductor area is saved in a chip integration design. If discrete devices are integrated, additional inductor BOM costs are saved. In addition, only the first capacitor CZ is an impedance matching element additionally disposed in the T-shaped network. Therefore, the T-shaped network does not need to be provided with a large quantity of impedance matching elements, and can achieve an equivalent effect of a λ/4 transmission line to replace the λ/4 transmission line, thereby reducing costs and area.

Refer to FIG. 2. The power amplifier 10 in this embodiment of this application may be used as a Doherty (Doherty) power amplifier, so that costs and area can be reduced, and efficiency can be further improved during power back-off. Certainly, the power amplifier in this embodiment of this application may alternatively be used as another power amplifier. This is not limited herein.

In this embodiment of this application, a type of the first capacitor CZ is not limited. For example, the first capacitor CZ may be a switched capacitor array, a variable capacitor, or a fixed capacitor. In this application, an example in which the first capacitor CZ is a variable capacitor is used.

Refer to FIG. 2. The first amplifier 11M and the second amplifier 11A may be completely symmetrically designed, and the first transformer 12M and the second transformer 12A are also completely symmetrically designed, so that a compact matching network design can be implemented, and devices can be completely symmetrically designed for main and auxiliary power amplifiers.

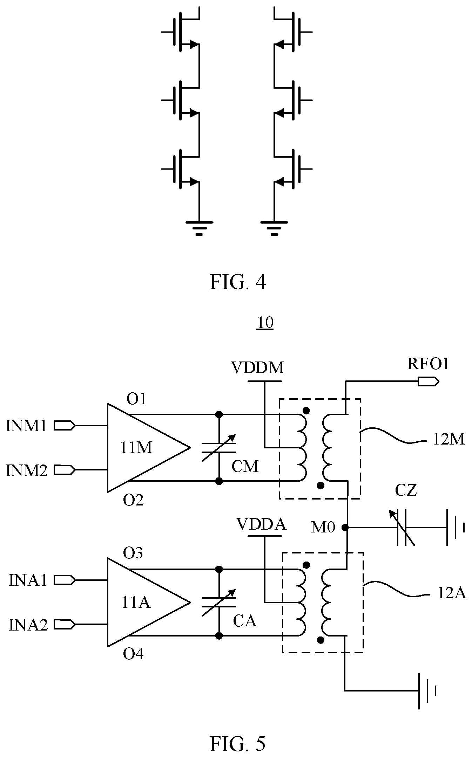

A circuit structure of the first amplifier 11M and a circuit structure of the second amplifier 11A in this embodiment of this application may be implemented as a cascode + stack structure. For example, for the cascode + stack structure, refer to FIG. 4. FIG. 4 is a diagram of a cascode + stack structure. A transistor at a bottommost layer is an amplification transistor. Transconductance of the amplification transistor converts an input voltage signal into a current signal, which is then converted into output power through a load network. In addition, the circuit structure of the first amplifier 11M and the circuit structure of the second amplifier 11A may be common, and turn-on time of the first amplifier 11M and the second amplifier 11A is adjusted and distinguished by adjusting a gate voltage of the amplification transistor. It may be understood that, in actual application, a quantity of stacked transistors may be flexibly adjusted based on a power supply voltage. Therefore, changes in the quantity of stacked transistors caused by voltage withstand requirements also fall within the protection scope of this application.

Still refer to FIG. 2. The first amplifier 11M may be a differential input/output amplifier. Specifically, the input end of the first amplifier 11M is a differential input end, and the differential input end of the first amplifier 11M is separately coupled to the first power input end INM1 and the first power input end INM2. In addition, the output end of the first amplifier 11M is a differential output end, and differential output ends O1 and O2 of the first amplifier 11M are respectively coupled to a first end and a second end of the primary coil of the first transformer 12M. A center tap of the primary coil of the first transformer 12M is configured to be coupled to a first power supply VDDM, to supply power to the first amplifier 11M through the first power supply VDDM. In this way, the first amplifier 11M can implement differential input and output. In addition, a specific voltage value of the first power supply VDDM is not limited in this application, and may be determined based on design requirements such as structural voltage withstand and target power of the first amplifier 11M. In addition, the first end of the primary coil of the first transformer 12M may be a positive end of the first transformer 12M, and the second end of the primary coil of the first transformer 12M may be a negative end of the first transformer 12M. Alternatively, the first end of the primary coil of the first transformer 12M may be a negative end of the first transformer 12M, and the second end of the primary coil of the first transformer 12M may be a positive end of the first transformer 12M. In addition, there is a first phase difference between a radio frequency signal input to the first power input end INM1 and a radio frequency signal input to the first power input end INM2, and the first phase difference is 180°.

Still refer to FIG. 2. The second amplifier 11A may alternatively be a differential input/output amplifier. In other words, the input end of the second amplifier 11A is a differential input end, and the differential input end of the second amplifier 11A is separately coupled to the second power input end INA1 and the second power input end INA2. In addition, the output end of the second amplifier 11A is a differential output end, and differential output ends O3 and O4 of the second amplifier 11A are respectively coupled to a first end and a second end of the primary coil of the second transformer 12A. A center tap of the primary coil of the second transformer 12A is configured to be coupled to a second power supply VDDA, to supply power to the second amplifier 11A through the second power supply VDDA. In this way, the second amplifier 11A can implement differential input and output. In addition, a specific voltage value of the second power supply VDDA is not limited in this application, and may be determined based on design requirements such as structural voltage withstand and target power of the second amplifier 11A. In addition, the first end of the primary coil of the second transformer 12A may be a positive end of the second transformer 12A, and the second end of the primary coil of the second transformer 12A may be a negative end of the second transformer 12A. Alternatively, the first end of the primary coil of the second transformer 12A may be a negative end of the second transformer 12A, and the second end of the primary coil of the second transformer 12A may be a positive end of the second transformer 12A. In addition, there is a second phase difference between a radio frequency signal input to the second power input end INA1 and a radio frequency signal input to the second power input end INA2, and the second phase difference is 180°. In addition, a difference between the first phase difference and the second phase difference is 90°.

The first transformer 12M in this embodiment of this application may be set as a balun (Balun) coil, so that the balun coil is used as an output matching transformer of the first amplifier 11M. Certainly, the first transformer 12M may alternatively be set in another structure form. This is not limited herein.

The second transformer 12A in this embodiment of this application may alternatively be set as a balun (Balun) coil, so that the balun coil is used as an output matching transformer of the second amplifier 11A. Certainly, the second transformer 12A may alternatively be set in another structure form. This is not limited herein.

It may be understood that a winding manner and an implementation form of the balun coil are not limited, a coupling coefficient and a turns ratio are related to designed power, and all fall within the protection scope of this application.

To avoid a problem in a combined signal, refer to FIG. 2. The positive end of the secondary coil of the first transformer 12M is coupled to the negative end of the secondary coil of the second transformer 12A. Certainly, the negative end of the secondary coil of the first transformer 12M may alternatively be coupled to the positive end of the secondary coil of the second transformer 12A.

In this embodiment of this application, the first amplifier 11M, the second amplifier 11A, the first transformer 12M, the second transformer 12A, and the first capacitor CZ may be packaged together and integrated into a chip. In this case, the first power input end (for example, INM1 and INM2), the second power input end (for example, INA1 and INA2), and the first output end RFO1 may be respectively pins of the chip. In addition, an example in which the first amplifier 11M, the second amplifier 11A, the first transformer 12M, the second transformer 12A, and the first capacitor CZ are one amplification unit is used. The power amplifier 10 may have one or more amplification units. When there is one amplification unit, the power amplifier has one output, to implement single-channel output. When there are a plurality of amplification units, the power amplifier may have a plurality of different output ends, to implement multi-channel output. For example, when there are two amplification units, the power amplifier may have two different output ends, to implement dual-channel output. It may be understood that power of a high-power single-channel Doherty power amplifier is usually 3 dB higher than power of a dual-channel low-power Doherty power amplifier.

FIG. 5 is a diagram of another structure of a power amplifier according to an embodiment of this application. Refer to FIG. 5. The power amplifier 10 in this embodiment is a variant of the power amplifier 10 in the embodiment shown in FIG. 2. Similarities thereof are not described herein again. A difference lies in that a second capacitor CM and a third capacitor CA are added to the amplification unit PZ. A first end of the second capacitor CM is coupled to the first end of the primary coil of the first transformer 12M, and a second end of the second capacitor CM is coupled to the second end of the primary coil of the first transformer 12M. In addition, a first end of the third capacitor CA is coupled to the first end of the primary coil of the second transformer 12A, and a second end of the third capacitor CA is coupled to the second end of the primary coil of the second transformer 12A. In this way, the parasitic inductance of the secondary coil of the first transformer 12M is adjusted via the second capacitor CM, and the parasitic inductance of the secondary coil of the second transformer 12A is adjusted via the third capacitor CA.

During specific implementation, a capacitance value of the first capacitor CZ, a capacitance value of the second capacitor CM, and a capacitance value of the third capacitor CA are separately adjustable. The parasitic inductance of the secondary coil of the first transformer 12M is tuned by adjusting the capacitance value of the second capacitor CM, the parasitic inductance of the secondary coil of the second transformer 12A is tuned by adjusting the capacitance value of the third capacitor CA, and in combination with tuning of the first capacitor CZ, a frequency selection characteristic of the T-shaped network is implemented. In other words, a multi-band adjustable T-shaped network is implemented, so that the power amplifier 10 in this embodiment of this application implements an effect of a broadband power amplifier (for example, a Doherty power amplifier).

In addition, in this embodiment of this application, Ropt (namely, an optimal load impedance of a transistor) of an output impedance of the power amplifier may be adjusted by adjusting the capacitance value of the first capacitor CZ, the capacitance value of the second capacitor CM, and the capacitance value of the third capacitor CA.

For example, the first capacitor CZ, the second capacitor CM, and the third capacitor CA may be separately set as switched capacitor arrays, so that the switched capacitor arrays can be switched based on an operating frequency of the power amplifier. Certainly, the first capacitor CZ, the second capacitor CM, and the third capacitor CA may alternatively be separately set as variable capacitors, and can also be switched based on an operating frequency of the power amplifier. This is not limited in this application.

It may be understood that the first capacitor CZ, the second capacitor CM, and the third capacitor CA may alternatively be separately set as fixed capacitors. In other words, capacitors with corresponding fixed capacitance values may be directly used as the first capacitor CZ, the second capacitor CM, and the third capacitor CA based on the operating frequency of the power amplifier.

During specific implementation, the first end of the second capacitor CM may alternatively not be coupled to the first end of the primary coil of the first transformer 12M, but the first end of the second capacitor CM is directly grounded. Alternatively, the first end of the third capacitor CA may alternatively not be coupled to the first end of the primary coil of the second transformer 12A, but the first end of the third capacitor CA is directly grounded.

For example, the first amplifier 11M, the second amplifier 11A, the first transformer 12M, the second transformer 12A, the first capacitor CZ, the second capacitor CM, and the third capacitor CA in this embodiment of this application may be packaged together and integrated into a chip.

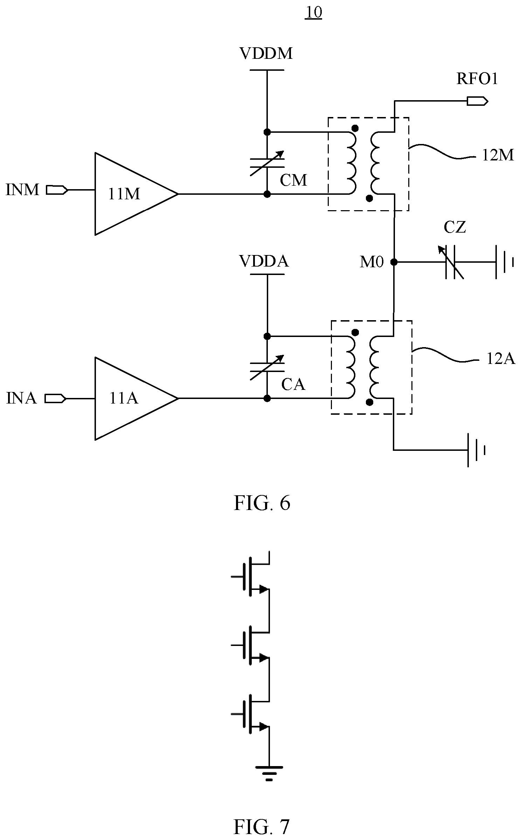

FIG. 6 is a diagram of still another structure of a power amplifier according to an embodiment of this application. Refer to FIG. 6. The power amplifier 10 in this embodiment is a variant of the power amplifier 10 in the embodiment shown in FIG. 5. Similarities thereof are not described herein again. A difference lies in that the first amplifier 11M and the second amplifier 11A are respectively single-ended input and single-ended output. Specifically, an input end of the first amplifier 11M is coupled to the first power input end INM, an output end of the first amplifier 11M is coupled to a second end of a primary coil of the first transformer 12M, and a first end of the primary coil of the first transformer 12M is configured to be coupled to the first power supply VDDM. In addition, the input end of the second amplifier 11A is coupled to the second power input end INA, the output end of the second amplifier 11A is coupled to the second end of the primary coil of the second transformer 12A, and the first end of the primary coil of the second transformer 12A is configured to be coupled to the second power supply VDDA. In addition, a first end of the second capacitor CM is coupled to the first end of the primary coil of the first transformer 12M, and a second end of the second capacitor CM is coupled to the second end of the primary coil of the first transformer 12M. A first end of the third capacitor CA is coupled to the first end of the primary coil of the second transformer 12A, and a second end of the third capacitor CA is coupled to the second end of the primary coil of the second transformer 12A.

In addition, for implementations of the first capacitor CZ, the second capacitor CM, and the third capacitor CA, refer to the foregoing embodiments. Details are not described herein again.

A circuit structure of the first amplifier 11M and a circuit structure of the second amplifier 11A in this embodiment of this application may alternatively be implemented as a cascode + stack structure. For example, for the cascode + stack structure, refer to FIG. 7. FIG. 7 is a diagram of a cascode + stack structure. A transistor at a bottommost layer is an amplification transistor. Transconductance of the amplification transistor converts an input voltage signal into a current signal, which is then converted into output power through a load network. In addition, the circuit structure of the first amplifier 11M and the circuit structure of the second amplifier 11A may be common, and turn-on time of the first amplifier 11M and the second amplifier 11A is adjusted and distinguished by adjusting a gate voltage of the amplification transistor. It may be understood that, in actual application, a quantity of stacked transistors may be flexibly adjusted based on a power supply voltage. Therefore, changes in the quantity of stacked transistors caused by voltage withstand requirements also fall within the protection scope of this application. In addition, there is also a phase difference between a radio frequency signal input to the first power input end INM and a radio frequency signal input to the second power input end INA, and the phase difference is 90°.

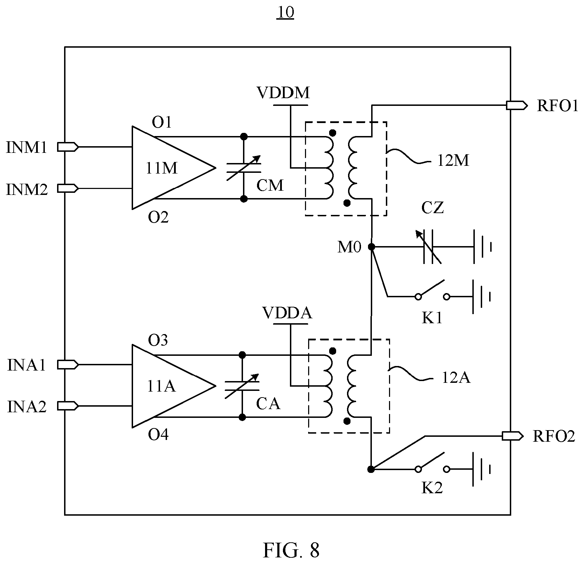

FIG. 8 is a diagram of another structure of a power amplifier according to an embodiment of this application. Refer to FIG. 8. The power amplifier 10 in this embodiment is a variant of the power amplifier 10 in the embodiment shown in FIG. 5. Similarities thereof are not described herein again. A difference lies in that, in addition to the first amplifier 11M, the second amplifier 11A, the first transformer 12M, the second transformer 12A, and the first capacitor CZ, the power amplifier 10 further includes a first switch K1 and a second switch K2. The first end of the secondary coil of the first transformer 12M is the first output end RFO1, the node M0 is separately coupled to the first end of the first capacitor CZ and a first end of the first switch K1, a second end of the first switch K1 is grounded, the second end of the secondary coil of the second transformer 12A is the second output end RFO2, the second end of the secondary coil of the second transformer 12A is coupled to a first end of the second switch K2, and a second end of the second switch K2 is grounded. In other words, the second end of the secondary coil of the second transformer 12A is grounded through the second switch K2. In this way, the power amplifier 10 in this embodiment of this application may be switched between a Doherty power amplifier and a multi-channel multiple-input multiple-output (Multiple-input multiple-output, MIMO) power amplifier 10 by turning on and off the first switch K1 and the second switch K2, so that the same power amplifier 10 in this embodiment of this application can be applied to different application scenarios.

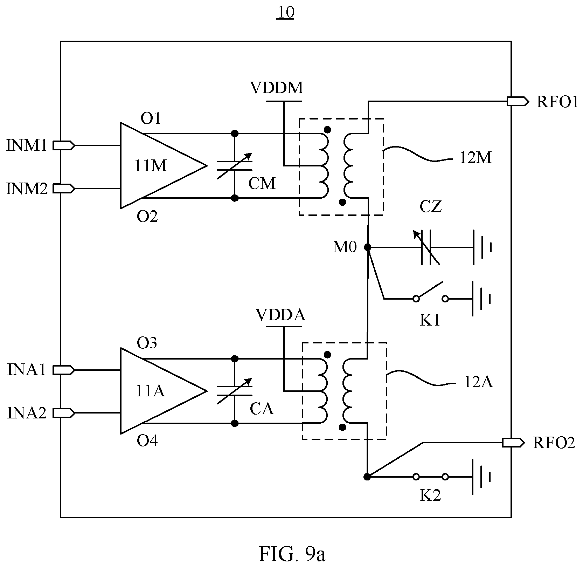

In some embodiments, to set the power amplifier in this embodiment of this application as a Doherty power amplifier, refer to FIG. 9a. FIG. 9a is a diagram of a structure of the power amplifier shown in FIG. 8 when the power amplifier is set as a Doherty power amplifier. The first switch K1 is controlled to be turned off, so that the node M0 is coupled to the first capacitor CZ. The second switch K2 is controlled to be turned on, so that the second end of the secondary coil of the second transformer 12A is grounded. In this way, the first capacitor CZ, the parasitic inductance of the secondary coil of the first transformer 12M, and the parasitic inductance of the secondary coil of the second transformer 12A form a T-shaped network, and the T-shaped network is used to convert a load impedance into a load impedance required by the first amplifier 11M, so that the first output end RFO1 is configured to output a power-amplified signal. In this way, the power amplifier 10 in this embodiment of this application may be set as a Doherty power amplifier, to meet a requirement of an application scenario. In addition, the second capacitor CM and the third capacitor CA are further disposed in the amplification unit PZ. The parasitic inductance of the secondary coil of the first transformer 12M is tuned by adjusting the capacitance value of the second capacitor CM, the parasitic inductance of the secondary coil of the second transformer 12A is tuned by adjusting the capacitance value of the third capacitor CA, and a multi-band adjustable T-shaped network is implemented in combination with tuning of the first capacitor CZ, and the power amplifier 10 in this embodiment of this application implements an effect of a broadband Doherty power amplifier.

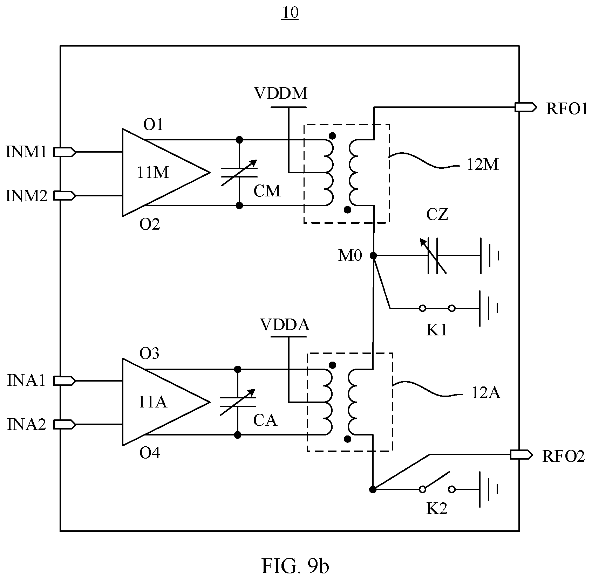

In some other embodiments, to set the power amplifier in this embodiment of this application as a MIMO power amplifier, refer to FIG. 9b. FIG. 9b is a diagram of a structure of the power amplifier shown in FIG. 8 when the power amplifier is set as a MIMO power amplifier. The first switch K1 is controlled to be turned on, so that the node M0 is grounded. The second switch K2 is controlled to be turned off, so that the second end of the secondary coil of the second transformer 12A is coupled to the second output end RFO2. In this way, the first output end RFO1 and the second output end RFO2 are respectively configured to output power-amplified signals. In this way, a radio frequency signal is input to the first amplifier 11M through the first power input end (for example, INM1 or INM2), and the first amplifier 11M amplifies the radio frequency signal, and couples an amplified radio frequency signal to the secondary coil of the first transformer 12M through the primary coil of the first transformer 12M. Then, a power-amplified radio frequency signal is output to the first output end RFO1 through the first end of the secondary coil of the transformer 12M. In addition, a radio frequency signal is input to the second amplifier 11A through the second power input end (for example, INA1 or INA2), and the second amplifier 11A amplifies the radio frequency signal, and couples an amplified radio frequency signal to the secondary coil of the second transformer 12A through the primary coil of the second transformer 12A. Then, a power-amplified radio frequency signal is output to the second output end RFO2 through the second end of the secondary coil of the second transformer 12A. In this way, the power amplifier 10 in this embodiment of this application may be set as a dual-output power amplifier 10, to meet a requirement of an application scenario. In addition, the second capacitor CM and the third capacitor CA are further disposed in the amplification unit PZ. The parasitic inductance of the secondary coil of the first transformer 12M is tuned by adjusting the capacitance value of the second capacitor CM, the parasitic inductance of the secondary coil of the second transformer 12A is tuned by adjusting the capacitance value of the third capacitor CA, and an effect of a broadband MIMO power amplifier is implemented in combination with tuning of the first capacitor CZ. It may be understood that, when the power amplifier in this embodiment of this application is set as a MIMO power amplifier, phases of a radio frequency signal input to the first power input end (for example, INM1 or INM2) and a radio frequency signal input to the second power input end (for example, INA1 or INA2) may be the same.

The power amplifier 10 in this embodiment of this application may be integrated into a packaged device 20. In other words, the packaged device 20 includes an amplification unit PZ, a first power input end (for example, INM1 and INM2), a second power input end (for example, INA1 and INA2), a first output end RFO1, and a second output end RFO2. For example, the packaged device 20 is a chip. In this case, the first power input end (for example, INM1 or INM2), the second power input end (for example, INA1 or INA2), the first output end RFO1, and the second output end RFO2 may be separately pins of the chip.

It may be understood that a coupling relationship between the first amplifier 11M and the first transformer 12M and a coupling relationship between the second amplifier 11A and the second transformer 12A may alternatively be the coupling relationship shown in FIG. 6. This is not limited herein.

In addition, refer to FIG. 8. The power amplifier in this embodiment of this application further includes the second capacitor CM and the third capacitor CA. In addition, for implementations of the first capacitor CZ, the second capacitor CM, and the third capacitor CA, refer to the foregoing embodiments. Details are not described herein again.

For example, the first amplifier 11M, the second amplifier 11A, the first transformer 12M, the second transformer 12A, the first capacitor CZ, the second capacitor CM, the third capacitor CA, the first switch K1, and the second switch K2 in this embodiment of this application may be packaged together and integrated into a chip.

It should be noted that a switch in embodiments of this application may be one or more of a plurality of types of switching devices, such as a metal-oxide semiconductor field-effect transistor (metal-oxide semiconductor field-effect transistor, MOSFET), a bipolar junction transistor (bipolar junction transistor, BJT), an insulated gate bipolar transistor (insulated gate bipolar transistor, IGBT), or a silicon carbide (SiC) MOSFET. The switching devices are not exhaustively listed in embodiments of this application. In addition, each switch may include a first electrode, a second electrode, and a control electrode, where the control electrode is configured to control turn-on or turn-off of the switch. When the switch is turned on, a current may be transmitted between the first electrode and the second electrode of the switch. When the switch is turned off, no current can be transmitted between the first electrode and the second electrode of the switch. A MOSFET is used as an example. A control electrode of the switch is a gate electrode, a first electrode of the switch may be a source electrode, and a second electrode may be a drain electrode; or the first electrode may be a drain electrode, and the second electrode may be a source electrode.

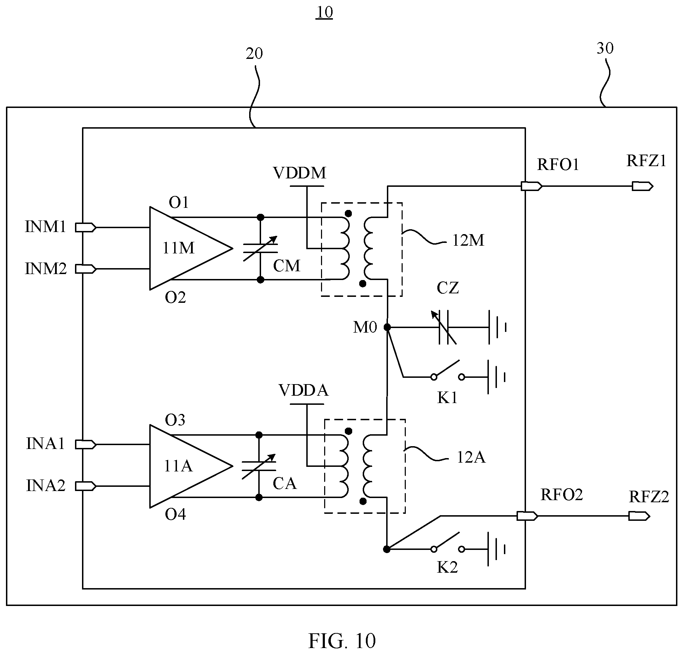

FIG. 10 is a diagram of another structure of a power amplifier according to an embodiment of this application. Refer to FIG. 10. The power amplifier 10 in this embodiment is a variant of the power amplifier 10 in the embodiment shown in FIG. 5. Similarities thereof are not described herein again. A difference lies in that the power amplifier 10 further includes a circuit board 30. The first amplifier 11M, the second amplifier 11A, the first transformer 12M, the second transformer 12A, the first capacitor CZ, the second capacitor CM, the third capacitor CA, the first switch K1, and the second switch K2 may be packaged together and integrated into a chip 20, and the chip 20 is disposed on the circuit board 30. The circuit board 30 includes a first power output end RFZ1 and a second power output end RFZ2. The first output end RFO1 is coupled to the first power transfer end RFZ1, to implement signal transmission between the first output end RFO1 and the first power transfer end RFZ1. The second output end RFO2 is coupled to the second power transfer end RFZ2, to implement signal transmission between the second output end RFO2 and the second power transfer end RFZ2. In this way, a power-amplified radio frequency signal may be output through the circuit board. In addition, the chip 20 and the circuit board are electrically coupled in a bonding manner like wire bonding or vertical interconnection structure bonding. It may be understood that a coupling relationship between the first amplifier 11M and the first transformer 12M and a coupling relationship between the second amplifier 11A and the second transformer 12A may alternatively be the coupling relationship shown in FIG. 6. This is not limited herein.

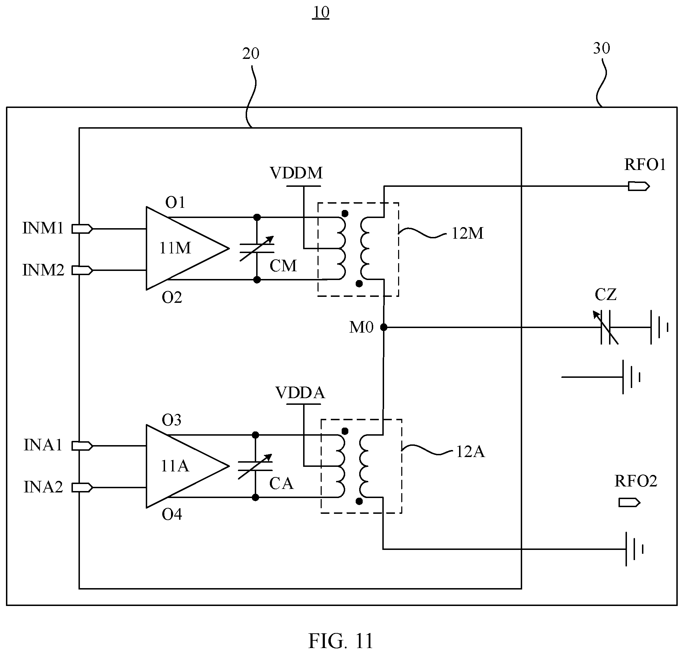

FIG. 11 is a diagram of another structure of a power amplifier according to an embodiment of this application. Refer to FIG. 11. The power amplifier 10 in this embodiment is a variant of the power amplifier 10 in the embodiment shown in FIG. 10. Similarities thereof are not described herein again. A difference lies in that the power amplifier 10 further includes a circuit board 30. The first amplifier 11M, the second amplifier 11A, the first transformer 12M, the second transformer 12A, the second capacitor CM, and the third capacitor CA may be packaged together and integrated into a chip 20, and the chip 20 is disposed on the circuit board 30. In addition, the first output end RFO1, the first capacitor CZ, and a ground end are disposed on the circuit board 30. In addition, the first amplifier 11M, the second amplifier 11A, the first transformer 12M, and the second transformer 12A are packaged together and then coupled to the first capacitor CZ. The first end of the secondary coil of the first transformer 12M is coupled to the first output end RFO1 on the circuit board 30, and the second end of the secondary coil of the second transformer 12A is coupled to the ground end on the circuit board 30. In this way, the first capacitor CZ is disposed on the circuit board 30, so that a size of the chip 20 can be reduced. In addition, the first capacitor CZ, the parasitic inductance of the secondary coil of the first transformer 12M, and the parasitic inductance of the secondary coil of the second transformer 12A may further form a T-shaped network, and the T-shaped network is used to convert a load impedance into a load impedance required by the first amplifier 11M, so that the power amplifier 10 in this embodiment of this application implements an effect of a Doherty power amplifier.

For example, the second output end RFO2 may be further disposed on the circuit board 30, but the second output end RFO2 is not coupled to the chip 20.

Further, the parasitic inductance of the secondary coil of the first transformer 12M is tuned by adjusting the capacitance value of the second capacitor CM, the parasitic inductance of the secondary coil of the second transformer 12A is tuned by adjusting the capacitance value of the third capacitor CA, and a multi-band adjustable T-shaped network is implemented in combination with tuning of the first capacitor CZ, and the power amplifier 10 in this embodiment of this application implements an effect of a width Doherty power amplifier. In addition, the second capacitor CM and the third capacitor CA may alternatively not be disposed in the power amplifier.

In addition, the packaged device 20 and the circuit board are electrically coupled in a bonding manner like wire bonding or vertical interconnection structure bonding.

It may be understood that a coupling relationship between the first amplifier 11M and the first transformer 12M and a coupling relationship between the second amplifier 11A and the second transformer 12A may alternatively be the coupling relationship shown in FIG. 6. This is not limited herein.

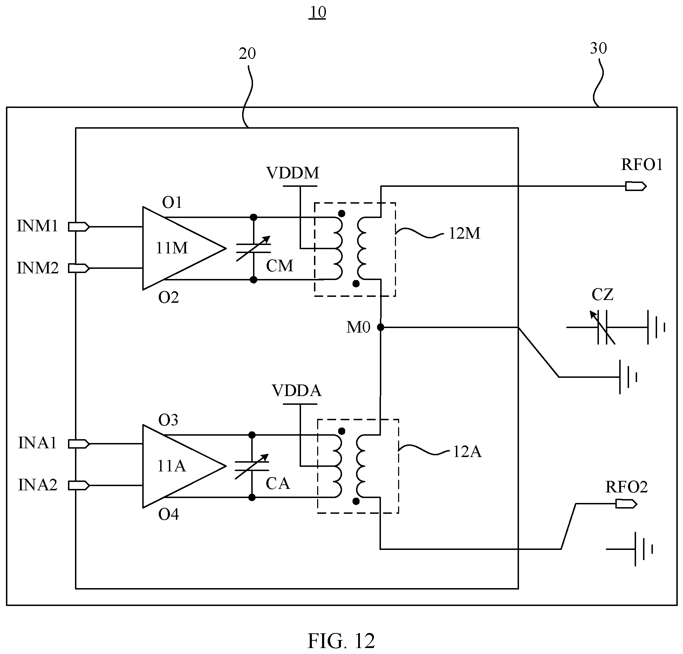

FIG. 12 is a diagram of another structure of a power amplifier according to an embodiment of this application. Refer to FIG. 12. The power amplifier 10 in this embodiment is a variant of the power amplifier 10 in the embodiment shown in FIG. 11. Similarities thereof are not described herein again. A difference lies in that the first output end RFO1, the second output end RFO2, and the ground end are disposed on the circuit board 30. In addition, the first amplifier 11M, the second amplifier 11A, the first transformer A2M, and the second transformer 12A are packaged together. The second end of the secondary coil of the first transformer 12M and the first end of the secondary coil of the second transformer 12A are coupled to the ground end on the circuit board 30. The first end of the secondary coil of the first transformer 12M is coupled to the first output end RFO1, and the second end of the secondary coil of the second transformer 12A is coupled to the second output end RFO2. In this way, the power amplifier 10 in this embodiment of this application is set as a MIMO power amplifier. It may be understood that a coupling relationship between the first amplifier 11M and the first transformer 12M and a coupling relationship between the second amplifier 11A and the second transformer 12A may alternatively be the coupling relationship shown in FIG. 6. This is not limited herein. In addition, the second capacitor CM and the third capacitor CA may alternatively not be disposed in the power amplifier.

It should be noted that the implementations in the foregoing embodiments may not depend on each other, and may alternatively be other implementations. This is not specifically limited herein.

The foregoing descriptions are merely specific implementations of this application, but are not intended to limit the protection scope of this application. Any variation or replacement readily figured out by a person skilled in the art within the technical scope disclosed in this application shall fall within the protection scope of this application.

## Claims

1. A power amplifier, comprising a first amplifier, a second amplifier, a first transformer, a second transformer, and a first capacitor, wherein
an output end of the first amplifier is coupled to at least one end of a primary coil of the first transformer, an output end of the second amplifier is coupled to at least one end of a primary coil of the second transformer, a first end of a secondary coil of the first transformer is a first output end, a second end of the secondary coil of the first transformer, a first end of a secondary coil of the second transformer, and a first end of the first capacitor are coupled to a point, a second end of the secondary coil of the second transformer is grounded, and a second end of the first capacitor is grounded.

2. The power amplifier according to claim 1, further comprising a first switch and a second switch, wherein
a first end of the first switch is coupled to the first end of the first capacitor, and a second end of the first switch is grounded; and
the second end of the secondary coil of the second transformer is grounded through the second switch, and the second end of the secondary coil of the second transformer is a second output end.

3. The power amplifier according to claim 2, wherein the first amplifier, the second amplifier, the first transformer, the second transformer, the first capacitor, the first switch, and the second switch are packaged together.

4. The power amplifier according to claim 1, wherein the first amplifier, the second amplifier, the first transformer, the second transformer, and the first capacitor are packaged together; or
the power amplifier further comprises a circuit board, wherein the first capacitor, a ground end, and the first output end are disposed on the circuit board, the first amplifier, the second amplifier, the first transformer, and the second transformer are packaged together and then coupled to the first capacitor, the first end of the secondary coil of the first transformer is coupled to the first output end on the circuit board, and the second end of the secondary coil of the second transformer is coupled to the ground end on the circuit board.

5. A power amplifier, comprising a first amplifier, a second amplifier, a first transformer, a second transformer, and a circuit board, wherein
an output end of the first amplifier is coupled to at least one end of a primary coil of the first transformer, an output end of the second amplifier is coupled to at least one end of a primary coil of the second transformer, a first end of a secondary coil of the first transformer is a first output end, and a second end of the secondary coil of the first transformer and a first end of a secondary coil of the second transformer are coupled to a point; and
the first output end, a second output end, and a ground end are disposed on the circuit board, the first amplifier, the second amplifier, the first transformer, and the second transformer are packaged together, the second end of the secondary coil of the first transformer and the first end of the secondary coil of the second transformer are coupled to the ground end on the circuit board, the first end of the secondary coil of the first transformer is coupled to the first output end, and a second end of the secondary coil of the second transformer is coupled to the second output end.

6. The power amplifier according to any one of claims 1 to 5, further comprising a second capacitor and a third capacitor, wherein
a first end of the second capacitor is coupled to a first end of the primary coil of the first transformer or grounded, and a second end of the second capacitor is coupled to a second end of the primary coil of the first transformer; and
a first end of the third capacitor is coupled to a first end of the primary coil of the second transformer or grounded, and a second end of the third capacitor is coupled to a second end of the primary coil of the second transformer.

7. The power amplifier according to claim 6, wherein a capacitance value of the first capacitor, a capacitance value of the second capacitor, and a capacitance value of the third capacitor are separately adjustable.

8. The power amplifier according to claim 7, wherein one or more of the first capacitor, the second capacitor, and the third capacitor are switched capacitor arrays.

9. The power amplifier according to any one of claims 1 to 8, wherein at least one of the first transformer and the second transformer is a balun coil.

10. The power amplifier according to any one of claims 1 to 9, wherein an input end of the first amplifier is a differential input end, the output end of the first amplifier is a differential output end, the differential output end of the first amplifier is separately coupled to the first end and the second end of the primary coil of the first transformer, and a center tap of the primary coil of the first transformer is configured to be coupled to a first power supply; or
an input end of the second amplifier is a differential input end, the output end of the second amplifier is a differential output end, the differential output end of the second amplifier is coupled to the first end and the second end of the primary coil of the second transformer, and a center tap of the primary coil of the second transformer is configured to be coupled to a second power supply.

11. The power amplifier according to any one of claims 1 to 9, wherein the output end of the first amplifier is coupled to the second end of the primary coil of the first transformer, and the first end of the primary coil of the first transformer is configured to be coupled to a first power supply; or
the output end of the second amplifier is coupled to the second end of the primary coil of the second transformer, and the first end of the primary coil of the second transformer is configured to be coupled to a second power supply.

12. A radio frequency front-end module, comprising the power amplifier according to any one of claims 1 to 11.

13. An electronic device, comprising the radio frequency front-end module according to claim 12.
